# EUROPEAN PATENT SPECIFICATION

(11) **EP 1 439 634 B1**
(45) Date of publication and mention of the grant of the patent: **15.11.2006**
(21) Application number: 04000144.8
(22) Date of filing: 07.01.2004
(51) Int. Cl.: H03J 5/24

(54) **Television tuner**
Fernsehtuner
Circuit d' accord de télévision

(30) Priority: 14.01.2003 JP 2003000144
(43) Date of publication of application: 21.07.2004
(73) Proprietor: ALPS ELECTRIC CO., LTD., Tokyo 145-8501 (JP)
(72) Inventor: Yamamoto, Masaki, Tokyo, 145-8501 (JP)
(74) Representative: Klunker . Schmitt-Nilson . Hirsch

(56) References cited:
- EP-A- 1 158 675

## Description

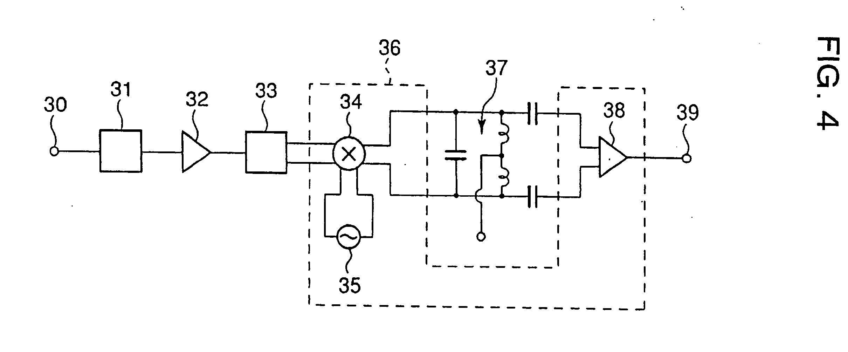

The present invention relates to a method of observing the RF characteristics of a television tuner. The structure of a known television tuner is shown in Fig. 4. Television signals input from an input port 30, such as a connector, are supplied to an input tuning circuit 31. The input tuning circuit 31 is tuned to, for example, VHF-high-band or VHF-low-band television signals. The television signals in the VHF-high band or VHF-low band are amplified by a high-frequency amplifier 32 and then selected by an interstage tuning circuit 33. The interstage tuning circuit 33 is also tuned to the VHF-high-band or VHF-low-band television signals.

The VHF-high-band or VHF-low-band television signals supplied to a mixer circuit 34 are mixed with balanced local oscillation signals from an oscillator 35 to be converted into intermediate-frequency signals. The mixer circuit 34 and the oscillator 35 are included in an integrated circuit 36. The balanced intermediate-frequency signals output from the mixer circuit 34 pass through a balanced intermediate-frequency tuning circuit 37 outside the integrated circuit 36 to be supplied to an intermediate-frequency amplifier 38. The intermediate-frequency amplifier 38 is also included in the integrated circuit 36. The amplified intermediate-frequency signals are output from an intermediate-frequency output terminal 39.

With the structure described above, although transmission characteristics from the input terminal 30 to the mixer circuit 34 (referred to as RF characteristics) are mainly determined by the input tuning circuit 31 and the interstage tuning circuit 33, the adjustment or confirmation of the RF characteristics is performed in the production process. Since the frequencies of the input television signals vary with different channels, the RF characteristics are observed at the output side of the mixer circuit 34 so as to be observed within the same frequency band.

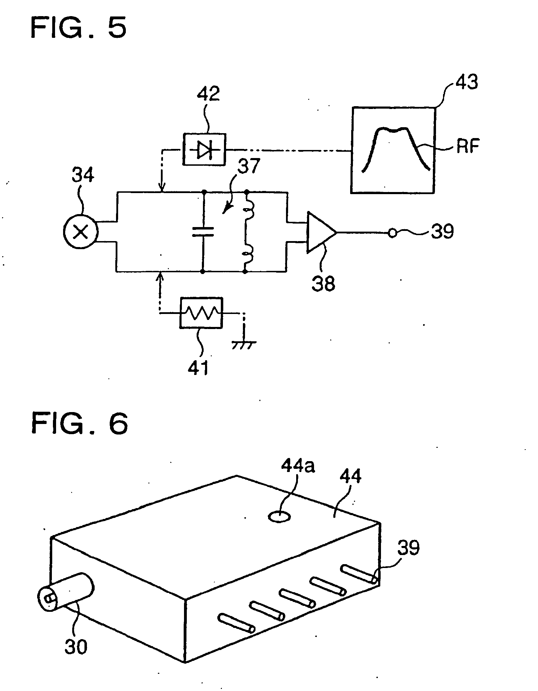

However, since the intermediate-frequency tuning circuit 37 is connected to the output side of the mixer circuit 34, the characteristics of the intermediate-frequency tuning circuit 37 are superimposed on the RF characteristics converted into the intermediate-frequency band. Hence, ordinarily, in the observation of the RF characteristics, as shown in Fig. 5, one end of the intermediate-frequency tuning circuit 37 is shunted by damper means 41 having a low resistance (several tens of ohms) and the other end thereof is connected to a detector 42. The detector 42 is connected to waveform observation equipment 43. With this structure, the Q factor of the intermediate-frequency tuning circuit 37 is reduced and the tuning characteristics of the intermediate-frequency tuning circuit 37 are slowly changed. The RF characteristics converted into the intermediate-frequency band appear at the output end of the mixer circuit 34. Displaying the RF characteristics in the waveform observation equipment 43 facilitates the adjustment or confirmation.

In order to perform the observation described above, a conductor land (not shown) with which the damper means 41 and the detector 42 are in contact is provided on a circuit board (not shown) having the mixer circuit 34 and the intermediate-frequency tuning circuit 37. Furthermore, as shown in Fig. 6, a hole 44a is provided on a cover 44 of the television tuner. Mounting the damper means 41 or the detector 42 in the hole 44a causes the damper means 41 or the detector 42 to be in contact with the conductor land.

The television tuner described above requires extra space for providing the conductor land for observation on the circuit board, thus preventing a reduction in size of the circuit board. A change in layout of the mixer circuit or the intermediate-frequency tuning circuit involves changing the position of the hole on the cover, and therefore, a change of design becomes disadvantageously complicated.

A television tuner is known from EP-A-1158675 which has an input terminal and a mixer circuit converting input television or FM broadcast signals into intermediate-frequency signals. This prior art tuner also comprises an intermediate-frequency tuning circuit to which the intermediate-frequency signals are supplied, and an intermediate-frequency output terminal from which the intermediate-frequency signals supplied from the intermediate- frequency tuning circuit are output. The intermediate-frequency tuning circuit includes a main tuning circuit tuned to the TV intermediate-frequency band during TV reception and an additional circuit, including reactance means and switching means connected to the reactance means. The tuning frequency of the intermediate-frequency tuning circuit is switched by using an external switching signal in order to turn on and off said switch means and to thereby either tune the intermediate-frequency tuning circuit to the TV intermediate-frequency band or tune the intermediate-frequency tuning circuit to the FM intermediate-frequency band.

Accordingly, an object of the present device is to provide a method capable of observing the RF characteristics, which appear at the output side of the mixer circuit, at the intermediate-frequency output terminal without being affected by the tuning characteristics of the intermediate-frequency tuning circuit.

In order to solve the above problem. The method comprises the features of the patent claim.

As described above, the television tuner of the present device includes a mixer circuit for converting input television signals into intermediate-frequency signals; an intermediate-frequency tuning circuit to which the intermediate-frequency signals are supplied; and an intermediate-frequency output terminal from which the intermediate-frequency signals supplied from the intermediate-frequency tuning circuit are output. The tuning frequency of the intermediate-frequency tuning circuit is switched by using external switching signals so as to be tuned to an intermediate-frequency band or a band outside the intermediate-frequency band. When the tuning frequency of the intermediate-frequency tuning circuit is tuned to a band outside the intermediate-frequency band, the high-frequency transmission characteristics of the television signals, which appear from the input terminal to the input port of the mixer circuit, appear at the intermediate-frequency output terminal without change. Hence, connecting the detector to the intermediate-frequency output terminal allows the waveform of the transmission characteristics to be easily observed, so that there is no need to provide a dedicated conductor land for observation on the integrated circuit, thus achieving a reduction in size of the integrated circuit. There is also no need to provide a hole for mounting the detector on the cover of the television tuner.

The intermediate-frequency tuning circuit includes a main tuning circuit tuned to the intermediate-frequency band and an additional circuit, including reactance means and switching means connected in series to the reactance means, connected in parallel to the main tuning circuit. The switching means is turned on or off with the switching signals. With this structure, the intermediate-frequency tuning circuit can be tuned to the intermediate-frequency band when the switching means is turned off, and the tuning frequency of the intermediate-frequency tuning circuit can be shifted to a frequency band lower than the intermediate-frequency band when the switching means is turned on.

Since the reactance means is a capacitive element and the switching means is a switching transistor, the tuning frequency of the intermediate-frequency tuning circuit can be easily switched.

At least the mixer circuit is included in an integrated circuit, and the capacitive element and the switching transistor are included in the integrated circuit, thus simplifying the structure of the entire television tuner, without additional parts.

### Brief Description of the Drawings

Fig. 1 is a circuit diagram showing the structure of a television tuner of the present device.
Fig. 2 is a diagram showing the waveform of the observed transmission characteristics in the television tuner of the present device.
Fig. 3 is a diagram showing the connection state in the observation of the transmission characteristics in the television tuner of the present device.
Fig. 4 is a circuit diagram showing the structure of a known television tuner.
Fig. 5 is a diagram showing the connection state in the observation of transmission characteristics in the known television tuner.
Fig. 6 is a perspective view of the known television tuner.

### Description of the Embodiments of the Invention

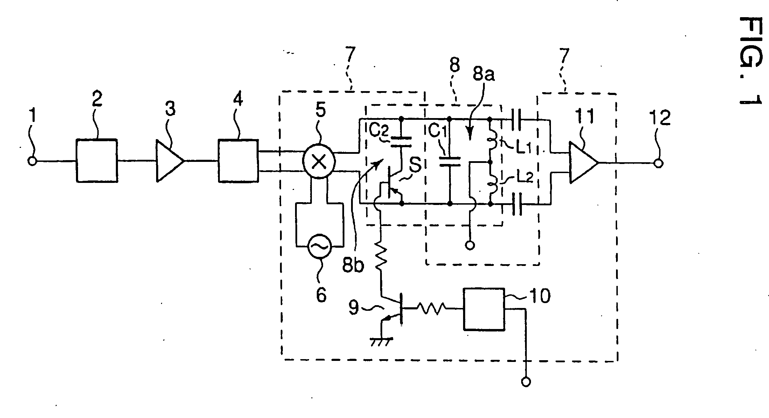

The structure of a television tuner of the present device is shown in Fig. 1. Television signals input from an input port 1, such as a connector, are supplied to an input tuning circuit 2. The input tuning circuit 2 is tuned to, for example, VHF-high-band or VHF-low-band television signals. The television signals in the VHF-high band or VHF-low band are amplified by a high-frequency amplifier 3 and then selected by an interstage tuning circuit 4. The interstage tuning circuit 4 is also tuned to the VHF-high-band or VHF-low-band television signals. The television signals differentially output from the interstage tuning circuit 4 are supplied to a mixer circuit 5.

The VHF-high-band or VHF-low-band television signals supplied to the mixer circuit 5 are mixed with balanced local oscillation signals from an oscillator 6 to be converted into intermediate-frequency signals. The mixer circuit 5 and the oscillator 6 are included in an integrated circuit 7. The balanced intermediate-frequency signals output from the mixer circuit 5 are supplied to an intermediate-frequency tuning circuit 8. The intermediate-frequency tuning circuit 8 includes a balanced main tuning circuit 8a that is arranged outside the integrated circuit 7 and an additional circuit 8b that is arranged in the integrated circuit 7 and is connected in parallel to the main tuning circuit 8a.

The main tuning circuit 8a is a parallel circuit including a capacitive element C1 and inductance elements L1 and L2, which are connected in series. The main tuning circuit 8a is tuned to an intermediate-frequency band. A supply voltage B that is applied to the connection point of the two inductance elements L1 and L2 is supplied to the mixer circuit 5. The additional circuit 8b is a series circuit including reactance means C2 and switching means S. The reactance means C2 is, for example, a capacitive element, and the switching means S is, for example, a switching transistor. The emitter of the switching transistor is connected to one end of the main tuning circuit 8a and the collector of the switching transistor is connected to the capacitive element. The reactance means C2 may be an inductance element.

The base of the switching transistor serving as the switching means S is connected to the collector of a driving transistor 9. The emitter of the driving transistor 9 is grounded and the base thereof is connected to a decoder circuit 10. Switching signals are externally supplied to the decoder circuit 10.

The intermediate-frequency signals output from the intermediate-frequency tuning circuit 8 are amplified by an intermediate-frequency amplifier 11. The amplified intermediate-frequency signals are externally output from the television tuner through an intermediate-frequency output terminal 12. The driving transistor 9 and the decoder circuit 10 are also included in the integrated circuit 7.

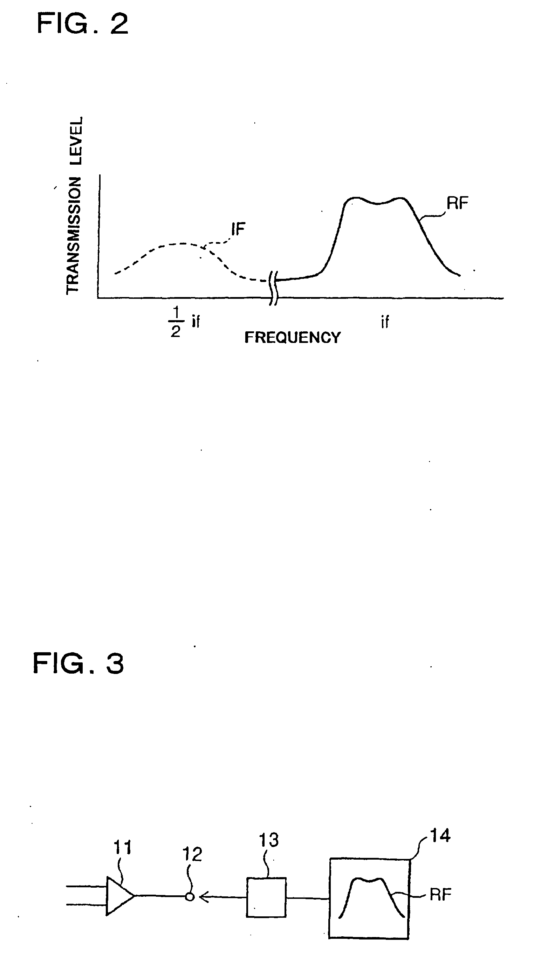

With the structure described above, in order to observe transmission characteristics (referred to as RF characteristics) from the input terminal 1 to the input port of the mixer circuit 5, a switching signal supplied to the decoder circuit 10 turns the driving transistor 9 on. Then, the switching means S in the additional circuit 8b is turned on for connecting the reactance means C2 in the additional circuit 8b to the main tuning circuit 8a, thus causing the tuning frequency of the intermediate-frequency tuning circuit 8 to be lower than the intermediate-frequency band. The tuning frequency here is preferably set to about half of the intermediate-frequency band if. Transmission characteristics (IF characteristics) of the intermediate-frequency tuning circuit are shown in Fig. 2, where the transmission characteristics of the intermediate-frequency tuning circuit widely shift from the intermediate-frequency band if. The RF characteristics (RF in Fig. 2), which undergo frequency conversion in the mixer circuit 5, appear within the intermediate-frequency band if.

The RF characteristics, which pass through the intermediate-frequency amplifier 11, are output from the intermediate-frequency output terminal 12. Hence, as shown in Fig. 3, connecting the intermediate-frequency output terminal 12 to a detector 13 that is connected to waveform observation equipment 14 allows the RF characteristics to be displayed in the waveform observation equipment 14. In this state, the RF characteristics can be adjusted or confirmed.

After the observation of the RF characteristics is completed, turning off the driving transistor 9 with the switching signal turns off the switching means S to disconnect the reactance means C2 from the main tuning circuit 8a. Accordingly, the intermediate-frequency tuning circuit 8 is tuned to the intermediate-frequency band (if), which is the characteristic of only the main tuning circuit 8a.

### Reference Numerals

- 1:: input terminal
- 2:: input tuning circuit
- 3:: high-frequency amplifier
- 4:: interstage tuning circuit
- 5:: mixer circuit
- 6:: oscillator
- 7:: integrated circuit
- 8:: intermediate-frequency tuning circuit
- 8a:: main tuning circuit
- C1:: capacitive element
- L1, L2:: inductance element
- 8b:: additional circuit
- C2:: reactance means
- S:: switching means
- 9:: driving transistor
- 10:: decoder
- 11:: intermediate-frequency amplifier
- 12:: intermediate-frequency output terminal
- 13:: detector
- 14:: waveform observation equipment

## Claims

1. A method of observing the RF transmission characteristics of a television tuner between an input terminal (1) and a mixer circuit (5) comprised in said tuner, said mixer circuit (5) converting input television signals into intermediate-frequency signals, said tuner further comprising an intermediate-frequency tuning circuit (8) to which the intermediate-frequency signals are supplied, and an intermediate-frequency output terminal (12) from which the intermediate-frequency signals supplied from the intermediate-frequency tuning circuit (8) are output, wherein the intermediate-frequency tuning circuit (8) includes a main tuning circuit (8a) tuned to the intermediate-frequency band and an additional circuit (8b), including reactance means (C2) and switching means (5) connected in series to the reactance means (C2), connected in parallel to the main turning circuit (8a) wherein the tuning frequency of the intermediate-frequency tuning circuit (8) is switched by using external switching signals in order to turn on and off said switch means (5) and to thereby either tune the intermediate-frequency tuning circuit (8) to an intermediate frequency band or de-tune the intermediate-frequency tuning circuit to a band outside the intermediate-frequency band and observe said RF transmission characteristics at said intermediate-frequency output terminal.

## Patentansprüche

1. Verfahren zum Beobachten der HF-Übertragungskennlinie eines Fernsehtuners zwischen einem Eingangsanschluss (1) und einer Mischerschaltung (5), die sich in dem Tuner befindet, wobei die Mischerschaltung (5) Eingangs-Fernsehsignale in Zwischenfrequenzsignale umwandelt, der Tuner außerdem eine Zwischenfrequenz-Abstimmschaltung (8) aufweist, der die Zwischenfrequenzsignale zugeleitet werden, und einen Zwischenfrequenz-Ausgangsanschluss (12), von dem die von der Zwischenfrequenz-Abstimmschaltung (8) gelieferten Zwischenfrequenzsignale ausgegeben werden, wobei die Zwischenfrequenz-Abstimmschaltung (8) eine Hauptabstimmschaltung (8a), die auf das Zwischenfrequenzband abgestimmt ist, und eine Zusatzschaltung (8b) die eine Reaktanzeinrichtung (C2) und eine zu der Reaktanzeinrichtung (C2) in Reihe geschalteten Schalteinrichtung (S) besitzt und der Hauptabstimmungschaltung (8a) parallel geschaltet, aufweist, wobei die Abstimmfrequenz der Zwischenfrequenz-Abstimmschaltung (8) unter Verwendung externer Schaltsignale umgeschaltet wird, um die Schalteinrichtung einzuschalten und abzuschalten und dadurch die Zwischenfrequenz-Abstimmschaltung (8) entweder auf das Zwischenfrequenzband abzustimmen oder die Zwischenfrequenz-Abstimmschaltung zu verstimmen auf ein Band außerhalb des Zwischenfrequenzbandes, und die HF-Übertragungskennlinie an dem Zwischenfrequenz-Ausgangsanschluss zu beobachten.

## Revendications

1. Procédé pour observer les caractéristiques de transmission HF d'un syntoniseur de télévision entre une borne d'entrée (1) et un circuit mélangeur (5) inclus dans ledit syntoniseur, ledit circuit mélangeur (5) convertissant des signaux de télévision d'entrée en signaux de fréquences intermédiaires, ledit syntoniseur comprenant en outre un circuit d'accord de fréquences intermédiaires (8) auquel sont transmis les signaux de fréquences intermédiaires, et une borne de sortie de fréquences intermédiaires (12) par laquelle sont délivrés les signaux de fréquences intermédiaires provenant du circuit d'accord de fréquences intermédiaires (8), le circuit d'accord de fréquences intermédiaires (8) comprenant un circuit d'accord principal (8a) accordé sur la bande de fréquences intermédiaires et un circuit supplémentaire (8b), comprenant un moyen à réactance (C2) et un moyen de commutation (S) monté en série avec le moyen à réactance (C2), monté en parallèle avec le circuit d'accord principal (8a), la fréquence d'accord du circuit d'accord de fréquences intermédiaires (8) étant commutée en utilisant des signaux de commutation externes afin de rendre passant et bloqué ledit moyen de commutation (S) pour soit accorder le circuit d'accord de fréquences intermédiaires (8) sur une bande de fréquences intermédiaires, soit désaccorder le circuit d'accord de fréquences intermédiaires sur une bande située à l'extérieur de la bande de fréquences intermédiaires et observer lesdites caractéristiques de transmission HF à la borne de sortie de fréquences intermédiaires.
